Europäisches Patentamt

European Patent Office

Office européen des brevets

(11) Veröffentlichungsnummer: **0 456 908 A1**

(12) **EUROPÄISCHE PATENTANMELDUNG**

(21) Anmeldenummer: 90125208.0

(22) Anmeldetag: 21.12.90

(51) Int. Cl.⁵: **C23C 18/28**

Ein Antrag gemäss Regel 88 EPÜ auf Berichtigung liegt vor. Über diesen Antrag wird im Laufe des Verfahrens vor der Prüfungsabteilung eine Entscheidung getroffen werden (Richtlinien für die Prüfung im EPA, A-V, 2.2).

(30) Priorität: 16.05.90 DE 4015717

(43) Veröffentlichungstag der Anmeldung:
21.11.91 Patentblatt 91/47

(84) Benannte Vertragsstaaten:
BE CH DE ES FR GB IT LI NL SE

(71) Anmelder: **BAYER AG**

**W-5090 Leverkusen 1 Bayerwerk(DE)**

(72) Erfinder: **Reichert, Günther, Dr.**
**Dünnwalder Mauspfad 358**
**W-5000 Köln 80(DE)**
Erfinder: **Giesecke, Henning, Dr.**
**Düsseldorfer Strasse 49**
**W-5000 Köln 80(DE)**
Erfinder: **Wolf, Gerhard Dieter, Dr.**
**Wilhelm-Busch-Strasse 29**
**W-4047 Dormagen 5(DE)**

(54) **Formulierung zum Aktivieren von Substratoberflächen für deren stromlose Metallisierung.**

(57) Zur Aktivierung von Kunststoffoberflächen für deren stromlose Metallisierung unter Vermeidung von Spannungsrißkorrosion eignen sich hervorragend Formulierungen, enthaltend einen metallorganischen Aktivator, einen Füllstoff, ein spezielles Gemisch organischer Lösungsmittel und ein PU-Elastomer.

Die so aktivierten Kunststoffteile werden nach erfolgter Metallisierung vorzugsweise zur Abschirmung von elektromagnetischen Wellen eingesetzt.

EP 0 456 908 A1

Es ist allgemein bekannt, daß polymere Werkstoffe vor dem chemischen Metallisieren vorbehandelt werden müssen, z.B. durch Ätzen der Polymeroberfläche mit Chromschwefelsäuren. Dieses Verfahren ist jedoch nur auf solche Polymeren anwendbar, deren Oberfläche sich oxidativ unter Bildung von Kavernen und Vakuolen verändern läßt.

Ferner ist bekannt, daß das Arbeiten mit Chromschwefelsäure, SO$_3$-Dampf oder anderen Oxidantien mit einer Verschlechterung der physikalischen Eigenschaften, wie der Kerbschlagzähigkeit und des elektrischen Oberflächenwiderstands des polymeren Werkstoffs, einhergeht. Darüber hinaus stören oftmals Spuren von sechswertigem Chrom, die rasch zu einer Vergiftung der Metallbäder führen.

Die bekannten Verfahren zur stromlosen Metallisierung von Werkstoffen bestehen im übrigen aus mehreren Verfahrensstufen und haben den Nachteil, daß sie nicht direkt auf alle Polymeren anwendbar sind. Oftmals muß eine chemische oder physikalische Aufrauhung durchgeführt werden.

Es ist deshalb bereits vorgeschlagen worden, die Polymeroberflächen sehr schonend mit metallorganischen Katalysatoren zu aktivieren (vgl. z.B. US-A 3 560 257 und EP-A 81 129). Diese an sich sehr elegante Methode ist indessen ebenfalls nicht universell anwendbar. Darüber hinaus führt der Einsatz von Lösungsmitteln häufig zur Auslösung der Spannungsrißkorrosion des unter Zug- oder Druckspannung stehenden Polymerspritzgußteiles.

Andere Verfahren, wie sie in US-A 3 560 257 und 4 017 265 sowie DE-A 3 627 256 beschrieben werden, haben den Nachteil, daß sie relativ größere Mengen an teuren Edelmetallaktivatoren erfordern,

Es wurde nun überraschenderweise gefunden, daß man ohne die genannten Nachteile, insbesondere unter Vermeidung der Spannungsrißkorrosion, gut haftende Metallschichten auf Kunststoffoberflächen erzeugen kann, wenn man diese ohne vorheriges Beizen mit einer Aktivatorformulierung auf der Basis von organischen Edelmetallverbindungen, Füllstoffen, organischen Lösungsmittelgemischen und Polyurethanelastomeren als Bindemittel behandelt, wobei als Lösungsmittelgemisch ein Gemisch aus Glykoletheracetaten, aliphatischen Ketonen und aliphatischen Alkoholen verwendet wird.

Bevorzugte Formulierungen enthalten:
a) 0,03 bis 3,0 Gew.-%
einer organischen Edelmetallverbindung als Aktivator,
b) 20 bis 60 Gew.-%
Glykoletheracetate,
c) 20 bis 60 Gew.-%
aliphatische Ketone,
d) 4 bis 60 Gew.-%
aliphatische Alkohole,
e) 0,5 bis 3,0 Gew.-%

Füllstoffe,
f) 4 bis 20 Gew.-%
Polyurethanelastomere als Bindemittel,
wobei die Summe der Bestandteile a) bis f) 100 Gew.-% ergeben muß.

Nach der Aktivierung wird in üblicher Weise metallisiert.

Es ist überraschend, daß die erfindungsgemäßen Formulierungen Spannungsrißkorrosion auf verschiedenen Kunststoffen vermeiden und gleichzeitig eine haftfeste Metallisierung bewirken, da auf Oberflächen, die nur mit einem Lösungsmittel behandelt worden sind, entweder sofortige Rißbildung im Kunststoff auftritt oder die Rißbildung bei lösungsmittelempfindlichen Kunststoffen zwar ausbleibt, dafür aber keine haftfeste bzw. eine ungleichmäßige Metallisierung aufgrund einer nicht gleichmäßigen Filmbildung erfolgt.

Bevorzugte Sprühaktivatorformulierungen enthalten deshalb ein Lösungsmittelgemisch aus:
30 - 60 Gew.-% Glykoletheracetaten
30 - 60 Gew.-% aliphatischen Ketonen
4 - 40 Gew.-% aliphatischen Alkoholen.

Unter Glykoletheracetaten werden im Sinne der Erfindung Umsetzungsprodukte von Ethylenglykol bzw. Propylenglykol mit aliphatischen Alkoholen und Essigsäure, wie z.B. Ethylenglykolethyletheracetat, Propylenglykolmethyletheracetat und Propylenglykolethyletheracetat verstanden.

Als bevorzugte aliphatische Ketone werden gradkettige, verzweigte oder cyclische Ketone mit 3 bis 7 Kohlenstoffatomen wie z.B. Methylethylketon, Methylisobutylketon oder Cyclohexanon, eingesetzt.

Als aliphatische Alkohole kommen gradkettige oder verzweigte Alkohole mit 2 bis 8 Kohlenstoffatomen wie Ethanol, n-Propanol, Isopropanol, n-Butanol und Isobutanol, die gegebenenfalls durch eine Ketogruppe substituiert sind, wie z.B. Diacetonalkohol, in Betracht.

Als Aktivatoren kommen in den erfindungsgemäßen Formulierungen organometallische Verbindungen der 1. und 8. Nebengruppen des Periodensystems (insbesondere Pd, Pt, Au, Ag) in Betracht, wie sie beispielsweise in den EP-A 34 485, 81 438, 131 198 beschrieben werden. Besonders geeignet sind organometallische Komplex-Verbindungen des Palladiums mit Olefinen (Dienen), mit $\alpha$ $\beta$-ungesättigten Carbonylverbindungen, mit Kronenethern und mit Nitrilen. Ganz besonders geeignet sind Bisacetonitrilpalladiumdichlorid, Butadienpalladiumdichlorid, 4-Cyclohexan-1,2-dicarbonsäureanhydridpalladiumdichlorid, Mesityloxidpalladiumdichlorid, 3-Hepten-2-on-palladiumchlorid und 5-Methyl-3-hexan-2-on-palladiumchlorid.

Es können auch Gemische dieser Verbindungen eingesetzt werden.

Als Füllstoffe kommen aus der Druck- bzw.

Lackierungstechnik bekannte Hilfsstoffe wie Pigmente, disperse Kieselsäuren, Ruße, Silikate, rheologische Additive und Tonmineralien in Betracht.

Die erfindungsgemäßen Bindemittel sind aus der Polyurethanchemie bekannt. Sie werden beispielsweise hergestellt durch Umsetzung von Polyestern und/oder Polyethern mit aromatischen Polyisocyanaten und einem Kettenverlängerer, z.B. einem niedermolekularen Diol, wie z.B. Butandiol oder Neopentylglykol.

Zur Herstellung einer lagerstabilen, versprühbaren und toxikologisch unbedenklichen Formulierung ist es vorteilhaft, Polyurethane einzusetzen, die keine freien Isocyanatgruppen mehr enthalten.

Als besonders geeignet haben sich lineare, aromatische Polyurethanelastomere erwiesen, wie sie beispielsweise aus Butandiolpolyadipat, Neopentylglykol und 4,4'-Diphenylmethandiisocyanat hergestellt werden.

Es können auch andere Bindemittel eingesetzt werden, wie z.B. Polyacrylatpolyole, Polyesterdiole und Polyetherdiole.

Neben den Aktivatoren, Füllstoffen, Bindemitteln und Lösungsmittelgemischen enthalten die Formulierungen gegebenenfalls Tenside, Verlaufsmittel, Farbstoffe und/oder Verschnittmittel wie z.B. Xylol, Toluol oder n-Butylacetat.

Die Herstellung der erfindungsgemäßen Formulierungen geschieht im allgemeinen durch Vermischen der Bestandteile. Das Einarbeiten der Formulierungskomponenten kann auch in getrennten Schritten durchgeführt werden. Beispielsweise kann man den Aktivator zuerst in einer Lösungsmittelkomponente der Gesamtformulierung, z.B. in Ketonen vorlösen bzw. dispergieren und anschließend den Füllstoff, z.B. Aerosil® zugeben.

In einem zweiten Schritt wird diese Zubereitung in das restliche Lösungsmittelgemisch, welches das Bindemittel enthält, eingerührt oder dispergiert.

Vorzugsweise durch Aufsprühen der erfindungsgemäßen Formulierungen mittels aus der Lackindustrie bekannten Verfahren können Oberflächen zum Zwecke einer haftfesten chemischen Metallisierung aktiviert werden. Selbstverständlich kann das Aufsprühen der Formulierungen durch Tauchen, Aufpinseln und Aufrollen ersetzt werden.

Als Substrate für das erfindungsgemäße Verfahren eignen sich Papier, Emaille, Keramik, Polyethylen, Polypropylen, Epoxidharze, Polyester, Polycarbonate, Polyamide, Polyimide, Polyhydantoine, ABS-Kunststoffe, Silikone, Polyvinylhalogenide und Polyvinylidenfluorid in Form von Folien, Platten, Papieren und Vliesen. Besonders bevorzugt sind Substrate, wie sie in der Elektronikindustrie als Gehäuse eingesetzt werden, z.B. ABS-und Polycarbonat-Kunststoffe bzw. deren Blends, Polyphenylensulfid, Polybutylenterephthalat und deren Blends und Polypropylenoxid.

Nach dem Aufbringen der erfindungsgemäßen Formulierungen auf die Oberfläche, z.B. die Innenseite eines Gehäuses, werden die Lösungsmittel entfernt. Dies geschieht durch Trocknen oder Tempern bei substratspezifischen Temperaturen, beispielsweise zwischen Raumtemperatur und 240 °C unter Normaldruck, erhöhtem Druck oder Vakuum. Die Trocknungszeit kann dabei variiert werden.

Die so behandelten Oberflächen müssen anschließend durch Reduktion aktiviert werden, z.B. durch Reduktionsmittel wie Formaldehyd, Hypophosphite, Rongalit und Borane.

Eine bevorzugt ausgeführte Form des Verfahrens besteht darin, daß die Reduktion im Metallisierungsbad gleich mit dem Reduktionsmittel der stromlosen Metallisierung durchgeführt wird. Dies gilt beispielsweise für Nickel- und Kupferbäder.

Die mit den erfindungsgemäßen Formulierungen behandelten Oberflächen können in einem weiteren Verfahrensschritt stromlos metallisiert werden. Die dafür in Frage kommenden Metallisierungsbäder sind in der Technik der stromlosen Metallisierung bekannt.

Die erfindungsgemäßen Formulierungen eignen sich besonders für die partielle Aktivierung geometrisch komplizierter Oberflächen, besonders zur Herstellung von ein- oder beidseitig metallisierten Formkörpern bzw. von innenseitig metallisierten Gehäuseteilen für die Elektronikindustrie zum Zwecke der elektromagnetischen Abschirmung. Durch dieses Verfahren können selbstverständlich auch strukturierte Metallflächen mittels einer geeigneten Maske hergestellt werden.

Bei den in den nachfolgenden Beispielen mit dem Buchstaben "®" gekennzeichneten Produkten handelt es sich um eingetragene Warenzeichen.

Beispiel 1

Aus Butandiolpolyadipat (MG 2000), Neopentylglykol und 4,4'-Diphenylmethan-diisocyanat wurde ein nicht reaktives Polyurethanelastomer hergestellt und in die folgende Aktivatorformulierung eingebracht:

| | |
|---|---|
| 0,5 g | Bisacetonitrilpalladiumdichlorid |
| 500 ml | Methoxypropylacetat (MPA) |
| 450 ml | Methylethylketon (MEK) |
| 50 ml | n-Butanol |
| 23 g | Aerosil® 380 (380 m²/g nach BET) |
| 75 g | Polyurethan |

Die Herstellung der Formulierung erfolgte so, daß das Polyurethan in MPA vorgelegt wurde, Methylethylketon und n-Butanol zugefügt, dann Bisacetonitrilpalladiumdichlorid eingerührt und zuletzt Aerosil® 380 eingerührt wurde.

Die so hergestellte Sprühaktivatorformulierung wurde mittels einer Sprühpistole mit Luftunterstützung auf spritzgegossenen Testplatten (100 x 150 mm) Spannungsrißfrei versprüht. Der Spritzabstand betrug ca. 40 cm; der Düsenquerschnitt betrug 1,5 mm; die Luftzudosierung (2 bis 6 Dar) konnte variiert werden.

Als Testplattensubstrat wurde ein Blend aus ABS-Polymerisat (Acrylnitril-Butadien-Styrol-Copolymerisat) und einem Polyester aus 4,4'-Dihydroxydiphenyl-2,2-propan und Kohlensäure eingesetzt.

Die besprühten spannungsrißfreien Testplatten wurden 1 h lang an der Luft getrocknet und dann 1 h im Trockenofen bei 70°C getempert. Die auf Raumtemperatur abgekühlten Testplatten wurden anschließend in ein handelsübliches Cu-Metallisierungsbad mit folgenden Konzentrationen: Cu = 3,3 g/l; Natriumhydroxid = 5,4 g/l und Formaldehyd = 9,2 g/l, das auch in dem folgenden Beispiel eingesetzt wurde, 3 h lang bei 20°C getaucht. Die Abscheidung von Kupfer erfolgte gleichmäßig, Es entstand eine geschlossenflächige Metallauflage.

Dann wurden die metallisierten Testplatten aus dem Metallbad entfernt und gründlich mit demineralisiertem Wasser abgespült und 1 h lang in einem Trockenschrank getempert.

Zur Messung der Haftfestigkeit der Metallschicht nach DIN 53 494 wurden die Testplatten mit einer galvanisch abgeschiedenen Cu-Schicht versehen,

Die Haftfestigkeit nach DIN 53 494 betrug: 15 N/25 mm

Beispiel 2

Die Herstellung der Sprühaktivatorformulierung erfolgte wie in Beispiel 1.

Die Formulierung wurde mittels einer Spritzpistole mit Luftunterstützung auf einer spritzgegossenen Testplatte (100 x 150 mm) aus einem Polycarbonat aus 4,4'-Dihydroxydiphenyl-2,2-propan und Kohlensäure spannungsrißfrei versprüht, die Platte nach Abtrocknen bei 100°C/1 h lang getempert, im Metallbad bei 20°C/1 h lang metallisiert und anschließend bei 100°C/1 h lang getempert. Man erhielt eine zusammenhängende Metallschicht.

Haftfestigkeit nach DIN 53 494: 10 N/25 mm.

Beispiel 3

Die Herstellung der Sprühaktivatorformulierung und die Durchführung des Verfahrens erfolgte wie in Beispiel 1. Als Substrat diente ein ABS-Polymerisat (AcrylnitrilButadien-Styrol-Copolymerisat).

Die Haftfestigkeit der Metallauflage betrug 8N/25 mm.

Beispiel 4

Die Herstellung der Sprühaktivatorformulierung erfolgte wie in Beispiel 1 aus folgenden Komponenten:

| 2,8 g | Bisacetonitrilpalladiumdichlorid |
| 600 ml | MPA |
| 300 ml | MEK |
| 100 ml | n-Butanol |
| 23 g | Aerosil® 380 (380 m$^2$/g nach BET) |
| 75 g | Polyurethan |

Die so hergestellte Formulierung wurde auf einer Testplatte aus einem Blend aus ABS-Polymerisat (Acrylnitril-Butadien-Styrol-Copolymerisat) und einem Polycarbonat aus 4,4'-Dihydroxydiphenyl-2,2-propan und Kohlensäure spannungsrißfrei versprüht, dann bei 70°C/1 h getempert, 3 h bei 20°C in einem stromlosen Cu-Bad behandelt, mit Wasser gründlich gespült und 1 h im Trockenofen bei 70°C getempert.

Haftfestigkeit nach DIN 53 494: 17 N/25 mm.

Beispiel 5

Die Herstellung der Sprühaktivatorformulierung erfolgte aus folgenden Komponenten:

| 2,8 g | Bisacetonitrilpalladiumdichlorid |
| 300 ml | MPA |
| 600 ml | MEK |
| 100 ml | n-Butanol |
| 23 g | Aerosil® 380 (380 m$^2$/g nach BET) |
| 75 g | Polyurethan |

Die Herstellung der Formulierung und die Durchführung erfolgte wie im Beispiel 4. Als Testplatte diente ein Blend aus ABS-Polymerisat (Acrylnitril-Butadien-Styrol-Copolymerisat) und einem Polcarbonat aus 4,4'-Dihydroxydiphenyl-2,2-propan und Kohlensäure.

Haftfestigkeit nach DIN 53 494: 5 N/25 mm.

Beispiel 6

Die Herstellung der Sprühaktivatorformulierung erfolgte aus folgenden Komponenten:

| 2,8 g | Bisacetonitrilpalladiumdichlorid |
| 600 ml | MPA |
| 300 ml | MEK |
| 100 ml | Isopropanol |
| 23 g | Aerosil® 380 (380 m$^2$/g nach BET) |
| 75 g | Polyurethan |

Die Herstellung der Formulierung und die Durchführung erfolgte wie im Beispiel 4. Als Testplatte wurde ein Blend aus ABS-Polymerisat (Acrylnitril-Butadien-Styrol-Copolymerisat) und einem Polycarbonat aus 4,4'-Dihydroxydiphenyl-2,2-propan und Kohlensäure eingesetzt.

Haftfestigkeit nach DIN 53 494: 15 N/25 mm.

Beispiel 7

Die Herstellung der Sprühaktivatorformulierung erfolgte aus folgenden Komponenten:

| | |
|---|---|
| 2,8 g | Bisacetonitrilpalladiumdichlorid |
| 300 ml | MPA |
| 600 ml | MEK |
| 100 ml | n-Butanol |
| 23 g | Aerosil® 380 (380 m²/g nach BET) |
| 75 g | Polyurethan |

Die Formulierung wurde auf Testplatten aus einem Polycarbonat aus 4,4'-Dihydroxyphenyl-2,2-propan und Kohlensäure versprüht, dann bei 100°C/1 h getempert, 3 h bei 20°C metallisiert, mit Wasser gründlich gespült und 1 h im Trockenofen bei 100°C getempert. Die chemische Cu-Schicht war ganzflächig und ohne Risse.

Haftfestigkeit nach DIN 53 494: 7 N/25 mm.

Beispiel 8

Die Herstellung der Sprühaktivatorformulierung erfolgte aus folgenden Komponenten:

| | |
|---|---|
| 2 g | Bisacetonitrilpalladiumdichlorid |
| 330 ml | MPA |
| 300 ml | MEK |
| 200 ml | Isopropanol |
| 200 ml | Diacetonalkohol |
| 15 g | Aerosil®380 (380 m²/g nach BET) |
| 75 g | Polyurethan |

Die Formulierung wurde auf Testplatten aus Polycarbonat, hergestellt aus einem Polycarbonat aus 4,4'-Dihydroxyphenyl-2,2-propan und Kohlensäure, versprüht. Dann wurden die Testplatten bei 100°C/1 h lang getempert, 2 h bei 24°C im Metallisierungsbad metallisiert und mit Wasser gründlich gespült. Man erhielt eine Metallschicht. Anschließend wurde noch 1 h bei 100°C getempert.

Haftfestigkeit nach DIN 53 494: 12 N/25 mm.

Beispiel 9

Die Herstellung der Sprühaktivatorformulierung erfolgte wie in Beispiel 8. Als Substrat diente ein Blend aus ABS-Polymerisat (Acrylnitril-Butadien-Styrol-Copolymerisat) und einem Polycarbonat aus 4,4'-Dihydroxydiphenyl-2,2-propan und Kohlensäure.

Nach Versprühen der Formulierung auf Testplatten, wurde bei 70°C/1 h lang getempert, dann 2 h lang bei 24°C im Metallisierungsbad metallisiert und mit Wasser gründlich gespült. Man erhielt eine zusammenhängende Metallschicht. Anschließend wurde noch 1 h bei 70°C getempert.

Haftfestigkeit nach DIN 53 494: 14 N/25 mm.

Beispiel 10

Die Herstellung der Sprühaktivatorformulierung erfolgte aus folgenden Komponenten:

| | |
|---|---|
| 2 g | Bisacetonitrilpalladiumdichlorid |
| 330 ml | MPA |
| 350 ml | MEK |
| 350 ml | Diacetonalkohol |
| 15 g | Aerosil®380 (380 m²/g nach BET) |
| 75 g | Polyurethan |

Die Formulierung wurde auf Testplatten aus Polycarbonat, hergestellt aus einem Polycarbonat aus 4,4'-Dihydroxydiphenyl-2,2-propan und Kohlensäure, versprüht. Die Platten wurden dann bei 100°C/1 h lang getempert, 2 h bei 24°C im Metallisierungsbad metallisiert und mit Wasser gründlich gespült. Man erhielt eine Metallschicht. Anschließend wurde noch 1 h bei 100°C getempert.

Haftfestigkeit nach DIN 53 494: 13 N/25 mm

Beispiel 11

Die Herstellung der Sprühaktivatorformulierung erfolgte wie in Beispiel 10.

Als Substrat diente ein Polymerblend wie in Beispiel 9. Nach Versprühen der Formulierung auf Testplatten wurde bei 70°C/1 h lang getempert, dann 2 h lang bei 24°C im Metallierungsbad metallisiert und mit Wasser gründlich gespült. Man erhielt eine Metallschicht. Anschließend wurde 1 h lang bei 70°C getempert.

Haftfestigkeit nach DIN 53 494: 12 N/25 mm.

Beispiel 12

Die Herstellung der Sprühaktivatorformulierung erfolgte aus folgenden Komponenten:

| | |
|---|---|
| 2,2 g | Bisacetonitrilpalladiumdichlorid |
| 185 ml | MPA |
| 175 ml | MEK |
| 175 ml | 2-Butoxyethanol |
| 15 g | Aerosil®380 (380 m²/g nach BET) |
| 37 g | Polyurethan |

Calciumcarbonat wurde der Formulierung zuletzt zugesetzt, kann aber auch an anderer Stelle bei der Herstellung der Formulierung zugesetzt werden.

Die Formulierung wurde auf Testplatten aus Polycarbonat wie in Beispiel 8 versprüht. Dann wurden die Platten bei 100°C 1 h lang getempert, 2 h bei 24°C in einem Kupferbad metallisiert und mit Wasser gründlich gespült.

Man erhielt eine Metallschicht. Anschließend wurde noch 1 h bei 100°C getempert.

Haftfestigkeit nach DIN 53 494: 10 N/25 mm.

Beispiel 13

Die Herstellung der Sprühaktivatorformulierung erfolgte wie in Beispiel 12.

Als Substrat diente ein Blend aus ABS-Polymerisat und einem Polyester wie in Beispiel 9.

Nach Versprühen der Formulierung auf Testplatten, wurde wie 70°C 1 h lang getempert, dann 2 h lang bei 24°C im Metallisierungsbad metallisiert und mit Wasser gründlich gespült. Man erhielt eine Metallschicht. Anschließend wurde noch 1 h bei 70°C getempert.

Haftfestigkeit nach DIN 53 494: 7 N/25 mm

Beispiel 14

Die Herstellung der Sprühaktivatorformulierung erfolgte aus folgenden Komponenten:

| | |
|---|---|
| 2,2 g | Bisacetonitrilpalladiumdichlorid |
| 185 ml | MPA |
| 175 ml | MEK |
| 175 ml | Diacetonalkohol |
| 15 g | Aerosil®380 (380 m²/g nach BET) |
| 37 g | Polyurethan |

Calciumcarbonat wurde der Formulierung zuletzt zugesetzt, kann aber auch an anderer Stelle bei der Herstellung der Formulierung zugesetzt werden.

Die Formulierung wurde auf Testplatten aus Polycarbonat wie in Beispiel 8 versprüht. Dann wurde bei 100°C 1 h lang getempert, 2 h bei 24°C im Metallisierungsbad metallisiert und mit Wasser gründlich gespült. Man erhielt eine Metallschicht. Anschließend wurde noch 1 h lang bei 100°C getempert.

Haftfestigkeit nach DIN 53 494: 10 N/25 mm

Beispiel 15

Die Herstellung der Sprühaktivatorformulierung erfolgte wie in Beispiel 14.

Als Substrat diente eine Blend aus ABS-Polymerisat und einem Polyester wie in Beispiel 9.

Nach Versprühen der Formulierung auf Testplatten wurde bei 70°C 1 h lang getempert, dann 2 h lang bei 24°C im Metallisierungsbad metallisiert und mit Wasser gründlich gespült. Man erhielt eine Metallschicht Anschließend wurde noch 1 h lang bei 70°C getempert.

Haftfestigkeit nach DIN 53 494: 14 N/25 mm.

**Patentansprüche**

1. Aktivatorformulierung zur Aktivierung von Substratoberflächen für deren stromlose Metallisierung auf der Basis von organischen Edelmetallverbindungen, Füllstoffen, organischen Lösungsmittelgemischen und Polyurethanelastomeren als Bindemittel, dadurch gekennzeichnet, daß das Lösungsmittelgemisch ein Gemisch aus Glykoletheracetaten, aliphatischen Ketonen und aliphatischen Alkoholen ist.

2. Aktivatorformulierung gemäß Anspruch 1, enthaltend
   a) 0,03 bis 3,0 Gew.-% organische Edelmetallverbindung als Aktivator,
   b) 20 bis 60 Gew.-% Glylkoletheracetate,
   c) 20 bis 60 Gew.-% aliphatische Ketone,
   d) 4 bis 60 Gew.-% aliphatische Alkohole,
   e) 0,5 bis 3,0 Gew.-% Füllstoff,
   f) 4 bis 20 Gew.-% Polyurethanelastomere,
   wobei die Summe der Bestandteile a) bis f) 100 Gew.-% ergeben muß.

3. Aktivatorformulierung gemäß Anspruch 2, dadurch gekennzeichnet, daß die Aktivatoren a) organometallische Palladiumverbindungen sind.

4. Aktivatorformulierung gemäß Anspruch 1, dadurch gekennzeichnet, daß die Lösungsmittelgemische aus einem aliphatischen Alkohol, Methylethylketon und Methoxypropylacetat bestehen.

5. Aktivatorformulierung gemäß Anspruch 1, dadurch gekennzeichnet, daß die Polyurethanelastomere aus einem Polyester mit endständigen OH-Gruppen, einem Polyisocyanat und einem Kettenverlängerer aufgebaut sind.

6. Verfahren zur Aktivierung von Substratoberflächen, für deren stromlose Metallisierung, dadurch gekennzeichnet, daß diese mit einer Formulierung gemäß den Ansprüchen 1 bis 5 behandelt werden.

7. Verfahren zur Herstellung von ein- oder beidseitig metallisierten Formkörpern bzw. Gehäuseteilen durch Aktivierung und stromlose Metallisierung, dadurch gekennzeichnet, daß ein gemäß Anspruch 6 aktiviertes Substrat getempert und reduziert wird und in einem stromlosen Metallisierungsbad behandelt wird.

8. Verwendung der Verfahrensprodukte gemäß Anspruch 7 zur Herstellung von ein- oder beidseitig metallisierten Formkörpern bzw. von Gehäuseteilen für die Abschirmung elektromagnetischer Wellen.

# EUROPÄISCHER RECHERCHENBERICHT

Nummer der Anmeldung

## EP 90 12 5208

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A,D | EP-A-0 256 395 (BAYER) <br> * Spalte 3, Zeilen 29-45 * <br><br> – – – – – | | C 23 C 18/28 |
| | | | **RECHERCHIERTE SACHGEBIETE (Int. Cl.5)** |
| | | | C 23 C |

Der vorliegende Recherchenbericht wurde für alle Patentansprüche erstellt

| Recherchenort | Abschlußdatum der Recherche | Prüfer |
|---|---|---|
| Den Haag | 09 August 91 | NGUYEN THE NGHIEP |